# EUROPEAN PATENT APPLICATION

(11) **EP 2 131 238 A1**
(43) Date of publication of application: **09.12.2009**
(21) Application number: 09700011.1
(22) Date of filing: 07.01.2009
(51) Int. Cl.: G03F 7/023, C08G 69/42, G03F 7/004, G03F 7/075

(54) **POSITIVE PHOTOSENSITIVE RESIN COMPOSITION, CURED FILM, PROTECTIVE FILM, INSULATING FILM, AND SEMICONDUCTOR DEVICE AND DISPLAY DEVICE USING THE CURED FILM**

(30) Priority: 11.01.2008 JP 2008003913
(71) Applicant: Sumitomo Bakelite Co., Ltd., Shinagawa-ku Tokyo 140-0002 (JP)
(72) Inventor: MIZUSHIMA, Ayako, Tokyo 140-0002 (JP); MAKABE, Hiroaki, Tokyo 140-0002 (JP); TAKEDA, Naoshige, Tokyo 140-0002 (JP)
(74) Representative: Müller, Christian Stefan Gerd
(86) International application number: PCT/JP2009/000023
(87) International publication number: WO 2009/087964

(57) **Abstract**

An objective of the present invention is to achieve both prevention of scum generation in an open area and improvement in sensitivity in patterning process of the positive photosensitive resin composition. This objective can be achieved by a positive photosensitive resin composition comprising an alkali-soluble resin (A) containing an ingredient having a molecular weight of 80,000 or more in 0.5 % or less and a photosensitizing agent (B), wherein the amount of said photosensitizing agent (B) is 10 parts by weight or more and 40 parts by weight or less to 100 parts by weight of said alkali-soluble resin (A).

## Description

### TECHNICAL FIELD

Positive photosensitive resin composition, cured film, protective film, insulating film, and semiconductor device and display device therewith

### BACKGROUND ART

The present invention relates to a positive photosensitive resin composition, a cured film, a protective film, an insulating film, and a semiconductor device and a display device therewith.

As an alkali-soluble resin contained in a positive photosensitive resin composition, there have recently been, for example, used resin compositions containing a phenol-novolac resin, a cresol-novolac resin or a vinyl phenol-novolac resin, a photo acid generator and a cross-linking agent, with high sensitivity, high resolution and further reduced film thinning during the development process (Patent References 1 and 2).

When using these positive photosensitive resin compositions in a practical process, exposure properties are of importance, particularly an exposure time which may lead to improvement in a throughput. Thus, there has recently been needed to provide a positive photosensitive resin composition with such high sensitivity that exposure can be conducted in a short time. Furthermore, since size reduction of a semiconductor requires formation of a finer pattern, there has been needed to provide a positive photosensitive resin composition with higher resolution.

However, in a conventional positive photosensitive resin composition, a scum (a residual positive photosensitive resin composition after a development process) may be generated in an open area in a positive photosensitive resin composition layer during patterning process. Particularly, recent needs for high sensitivity and high resolution requires improved contrast in solubility between an exposed part and an unexposed part, and thus a scum is likely to occur when an exposed part of a positive photosensitive resin composition has insufficient solubility.

An alkali-soluble resin has been generally controlled based on a weight-average molecular weight, a number-average molecular weight and a dissolution rate as a measure of solubility in an alkaline developer, but it has become more difficult to completely prevent scum from being generated by such an approach.

Patent Document 1 : Japanese Laid-open Patent Publication No.H7-199464;
Patent Document 2: Japanese Laid-open Patent Publication No.H11-258808.

### DISCLOSURE OF THE INVENTION

In view of such a situation, an objective of the present invention is to achieve both prevention of scum generation in an open area and improvement in sensitivity in patterning process of the positive photosensitive resin composition. Another objective is to provide a highly reliable semiconductor device or display device.

Such objectives can be achieved by the present invention as described in [1] to [12].
[1] A positive photosensitive resin composition comprising an alkali-soluble resin (A) containing an ingredient having a molecular weight of 80,000 or more in 0.5 % or less and a photosensitizing agent (B), wherein the amount of said photosensitizing agent (B) is 10 parts by weight or more and 40 parts by weight or less to 100 parts by weight of said alkali-soluble resin (A).
[2] The positive photosensitive resin composition as described in [1], wherein said alkali-soluble resin (A) is a compound having a repeating unit represented by general formula (1):

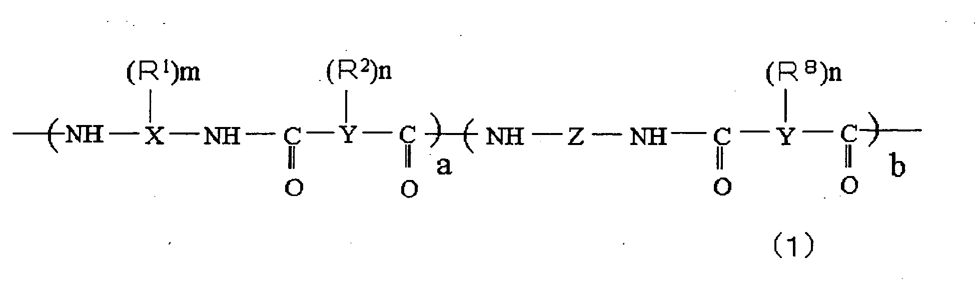

wherein X and Y are an organic group; a and b represents a molar percentage, and when a+b=100, a is 60 or more and 100 or less and b is 0 or more and 40 or less; R¹ is hydroxy group, -O-R³ or an organic group having 1 to 15 carbon atoms and when a plurality of R¹s exist, these may be the same or different; R² and R⁸ are hydroxy group, carboxyl group, -O-R³ or -COO-R³ and when a plurality of R²s and R⁸s exist, these may be the same or different; m is an integer of 0 to 4; n is an integer of 0 to 4; R³ is an organic group having 1 to 15 carbon atoms, provided that when there are no R¹s as hydroxy group, at least one of R²s and R⁸s must be carboxyl group and when there are no R²s nor R⁸s as carboxyl group, at least one of R¹s must be hydroxy group; Z is represented by -R⁴-Si(R⁶)(R⁷)-O-Si(R⁶)(R⁷)-R⁵- wherein R⁴ to R⁷ are an organic group.
[3] The positive photosensitive resin composition as described in [1] or [2], wherein said photosensitizing agent (B) is a diazonaphthoquinone compound.
[4] The positive photosensitive resin composition as described in any of [1] to [3], further comprising a compound (C) having phenolic hydroxy group.
[5] The positive photosensitive resin composition as described in any of [1] to [4], wherein X in general formula (1) contains a structure represented by formula (2):

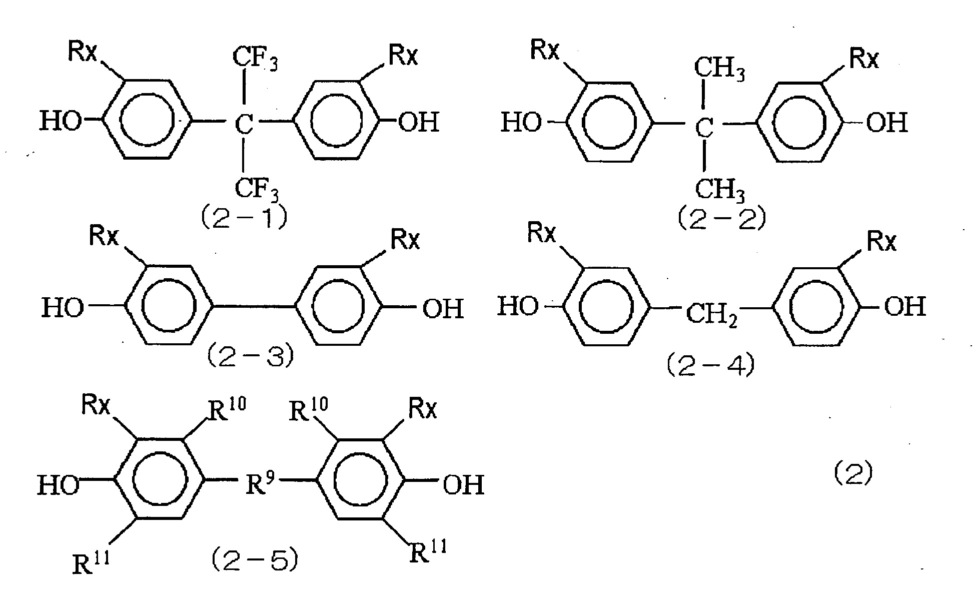

wherein Rx indicates bonding to NH; R⁹ is an organic group selected from the group consisting of alkylene, substituted alkylene, -O-, -S-, -SO₂-, -CO-, -NHCO- and a single bond; R¹⁰s, which may be the same or different, are alkyl group, alkoxy group, acyloxy group or cycloalkyl group; R¹¹s, which may be the same or different, is hydrogen, alkyl group, alkoxy group, acyloxy group or cycloalkyl group.

[6] The positive photosensitive resin composition as described in any of [1] to [4], wherein X in general formula (1) contains a structure represented by formula (3):

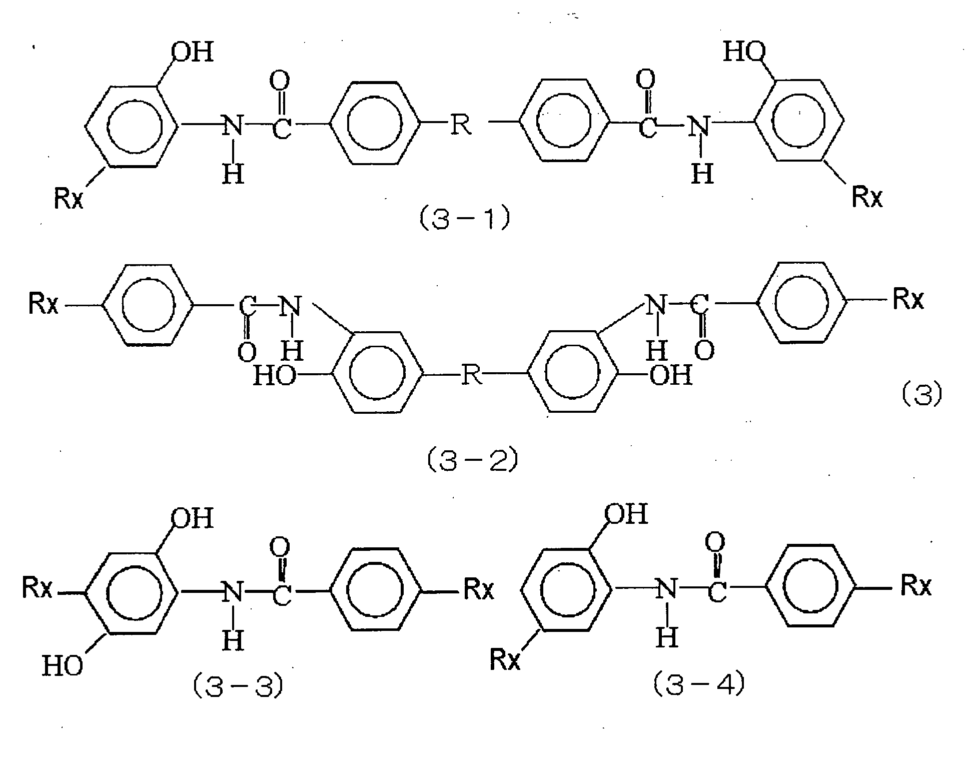

wherein Rx indicates bonding to NH; and R is -C(CH₃)₂-, -SO₂-, -C(CF₃)₂- or a single bond.

[7] The positive photosensitive resin composition as described in any of [1] to [6], wherein Y in general formula (1) contains a structure represented by formula [4]:

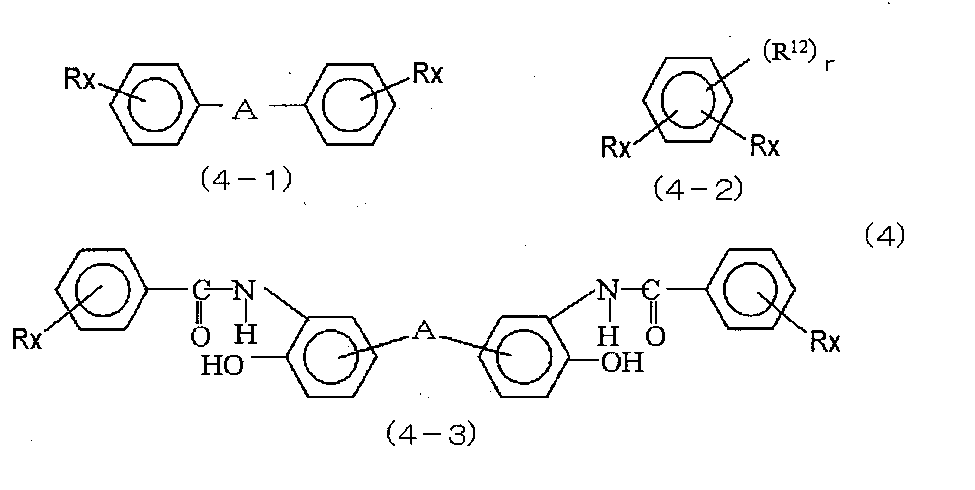

wherein Rx indicates bonding to C=O; A is -CH₂-, -C(CH₃)₂-, -O-, -S-, -SO₂-, -CO-, -NHCO-, -C(CF₃)₂- or a single bond; and R¹²s, which may be the same or different, represents one selected from the group consisting of alkyl, alkyl ester, alkyl ether, benzyl ether and halogen.

[8] A cured film composed of a cured product of the positive photosensitive resin composition as described in any of [1] to [7].
[9] A protective film consisting of the cured film as described in [8].
[10] An insulating film consisting of the cured film as described in [8].
[11] A semiconductor device comprising the cured film as described in [8].
[12] A display device comprising the cured film as described in [8].

### BEST MODE FOR CARRYING OUT THE INVENTION

There will be described a positive photosensitive resin composition and a semiconductor device of the present invention.

### 1. Positive photosensitive resin composition

A positive photosensitive resin composition of the present, invention is **characterized in that** it contains an alkali-soluble resin (A) containing an ingredient having a molecular weight of 80,000 or more in 0.5 % or less and a photosensitizing agent (B), wherein the amount of said photosensitizing agent (B) is 10 parts by weight or more and 40 parts by weight or less to 100 parts by weight of said alkali-soluble resin (A). In particular, since it contains an alkali-soluble resin (A) containing an ingredient having a molecular weight of 80,000 or more in 0.5% or less, scum generation can be prevented in an open area in the positive photosensitive resin composition opening during patterning the positive photosensitive resin composition, resulting in higher reliability of a semiconductor device.

Examples of an alkali-soluble resin (A) in the present invention include, but not limited to, cresol-type novolac resins; hydroxystyrene resins; acrylic resins such as methacrylic resins and methacrylate resins; cyclic olefin resins containing hydroxy group, carboxyl group or the like; and polyamide resins. Among these, preferred are polyamide resins in terms of excellent heat resistance and mechanical properties; specific examples include a resin having at least one of a polybenzoxazole and a polyimide structures and having a hydroxy, carboxyl, ether or ester group in its main or side chain, a resin having a polybenzoxazole precursor structure, a resin having a polyimide precursor structure and a resin having a polyamide acid ester structure. An example of such a polyamide resin may be a polyamide resin represented by general formula (1):

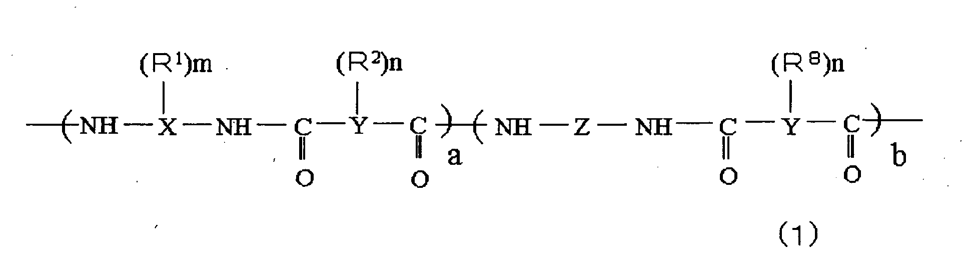

wherein X and Y are an organic group; a and b represents a molar percentage, and when a+b=100, a is 60 or more and 100 or less and b is 0 or more and 40 or less; R¹ is hydroxy group, -O-R³ or an organic group having 1 to 15 carbon atoms and when a plurality of R¹s exist, these may be the same or different; R² and R⁸ are hydroxy group, carboxyl group, -O-R³ or -COO-R³ and when a plurality of R²s and R⁸s exist, these may be the same or different; m is an integer of 0 to 4; n is an integer of 0 to 4; R³ is an organic group having 1 to 15 carbon atoms, provided that when there are no R¹s as hydroxy group, at least one of R²s and R⁸s must be carboxyl group and when there are no R²s nor R⁸s as carboxyl group, at least one of R¹s must be hydroxy group; Z is represented by -R⁴-Si(R⁶)(R⁷)-O-Si(R⁶)(R⁷)-R⁵- wherein R⁴ to R⁷ are an organic group.

Solubility of the alkali-soluble resin (A) in an alkaline developer considerably depends on a molecular weight of the alkali-soluble resin (A), and thus generally, a large weight-average molecular weight may reduce solubility in an alkaline developer, leading to increased scum occurrence. However, a scum may or may not occur in patterning a positive photosensitive resin composition containing an alkali-soluble resin (A) having the same weight-average molecular weight, and after intensely investigating its cause, we have found that a scum tends to occur with a high content of a polymer having a high molecular weight in an alkali-soluble resin (A). More specifically, a scum can be prevented in patterning process, by controlling a content of a polymer having a molecular weight of 80,000 or more in an alkali-soluble resin (A) to 0.5 % or less.

Examples of a polyamide resin represented by general formula (1) include, but not limited to, a polyamide resin composed of a structure unit formed by reacting a compound selected from, for example, a diamine or a bis (aminophenol) and 2,4-diaminophenol containing X with a compound selected from, for example, a tetracarboxylic anhydride, a trimellitic anhydride, a dicarboxylic acid or a dicarboxylic dichloride, a dicarboxylic acid derivative, a hydroxydicarboxylic acid and a hydroxydicarboxylic acid derivative containing Y, and/or a structure unit formed by reacting a silicon diamine containing Z with a compound selected from, for example, tetracarboxylic anhydride, trimellitic anhydride, dicarboxylic acid, dicarboxylic dichloride, dicarboxylic acid derivative, hydroxycarboxylic acid, hydroxydicarboxylic acid derivative containing Y.
For a dicarboxylic acid compound, an activated ester type dicarboxylic acid derivative pre-treated with, for example, 1-hydroxy-1,2,3-benzotriazole may be used for improving a reaction yield.

A content of an ingredient having a molecular weight of 80,000 or more can be easily controlled to 0.5 % or less in the polyamide resin by appropriately adjusting a temperature and a time during the synthesis, although depending on a material used for synthesis of the polyamide resin. Furthermore, the ingredient having a molecular weight of 80,000 or more can be removed by appropriate precipitation process after the synthesis of the polyamide resin. Thus, a content of the ingredient having amolecular weight of 80, 000 or more can be reduced. Furthermore, by appropriately adjusting a precipitation temperature, the ingredient having a higher molecular weight can be reduced. A precipitation temperature is preferable, for example, 20 to 24 °C. There are no particular restrictions to the number of precipitation and it may be conducted twice or more. The above approach is just illustrative, but not limiting.

In a polyamide resin represented by general formula (1), -O-R³ as a substituent of X and -O-R³ and -COO-R³ as a substituent of Y are a hydroxy and a carboxyl groups protected by an organic group, R³ having 1 to 15 carbon atoms for adjusting its solubility in an alkaline aqueous solution, where a hydroxy or carboxyl groups may be, if necessary, protected. Examples of R³ include formyl group, methyl group, ethyl group, propyl group, isopropyl group, tert-butyl group, tert-butoxycarbonyl group, phenyl group, benzyl group, tetrahydrofuranyl group and tetrahydropyranyl group.

Examples of an organic group having 1 to 15 carbon atoms as a substituent of X in a polyamide resin represented by general formula (1) include, but not limited to, methyl group, ethyl group, propyl group, isopropyl group, tert-butyl group, methoxy group, ethoxy group and cyclohexyl group, preferablymethyl group which may give a film having good physical properties after curing.

By heating, a polyamide resin represented by general formula (1) is subjected to dehydration and cyclization to give a heat resistant resin as a polyimide resin, a polybenzoxazole resin or a copolymer of these.

Examples of X in a polyamide resin represented by general formula (1) include, but not limited to, those represented by formulas (5) and (6):

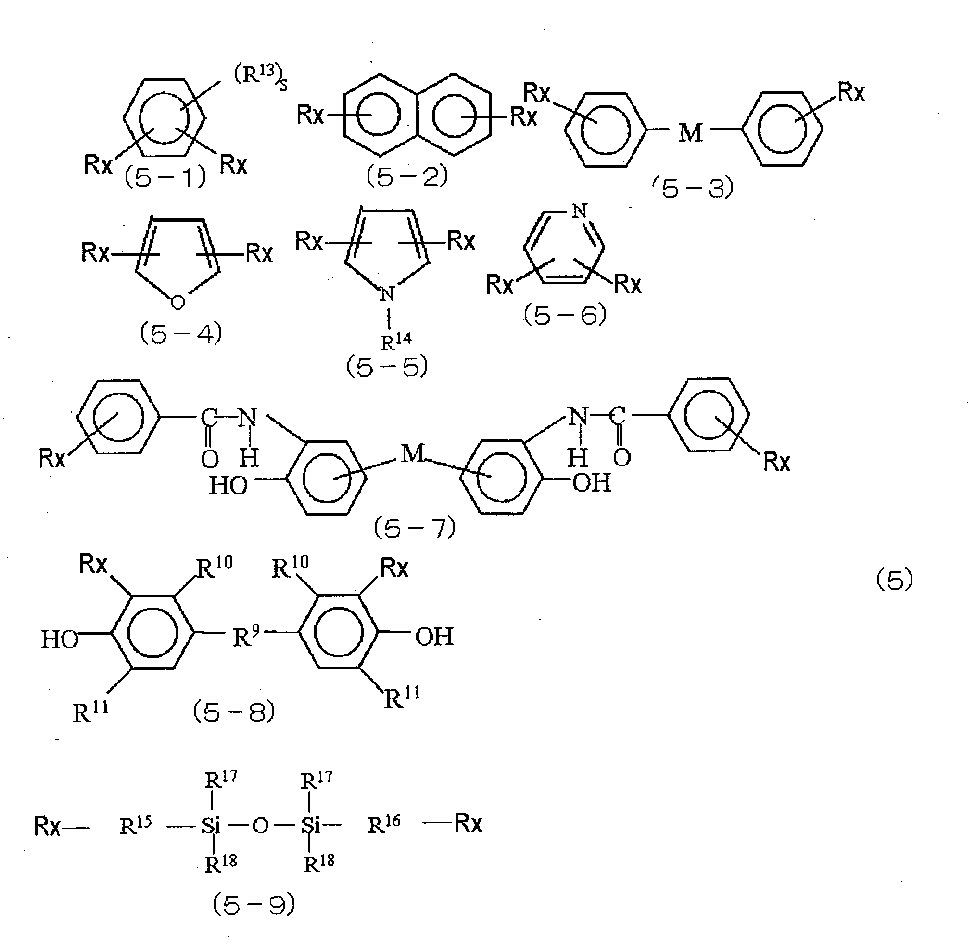

wherein Rx indicates bonding to NH; M is -CH₂-, -C (CH₃)₂-, -O-, -S-, -SO₂-, -CO-, -NHCO-, -C(CF₃)₂- or a single bond; R¹³s, which may be the same or different, represent one selected from the group consisting of alkyl, alkyl ester and halogen; s is a positive number of 0 to 2; R¹⁴ represents one selected from the group consisting of hydrogen, alkyl, alkyl ester and halogen; R⁹ is an organic group selected from the group consisting of alkylene, substituted alkylene, -O-, -S-, -SO₂-, -CO-, -NHCO-, a single bond or the group of formula (6); R¹⁰s, which may be the same or different, are alkyl group, alkoxy group, acyloxy group or cycloalkyl group; R¹¹s, whichmaybe the same or different, is hydrogen, alkyl group, alkoxy group, acyloxy group or cycloalkyl group; and R¹⁵ to R¹⁸ are an organic group.

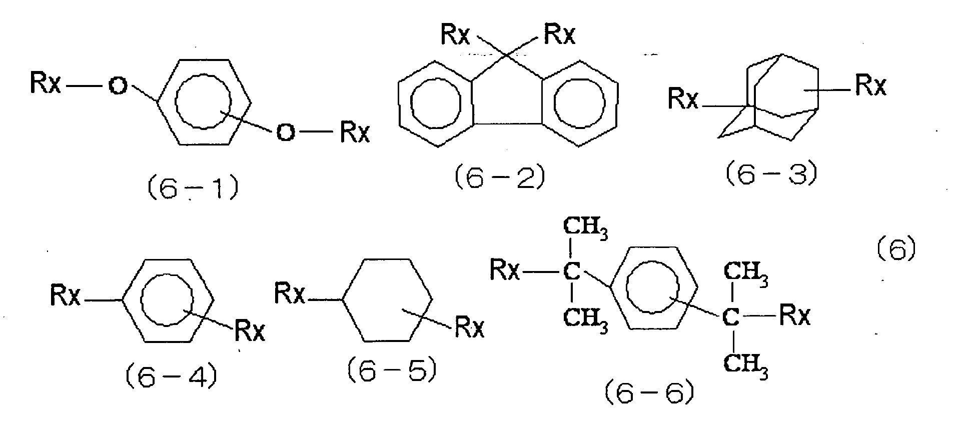

wherein Rx indicates bonding to NH.

Among these, preferred are those represented by formula (7) in the light of a positive photosensitive resin composition having a good patterning properties and its cured film having good physical properties:

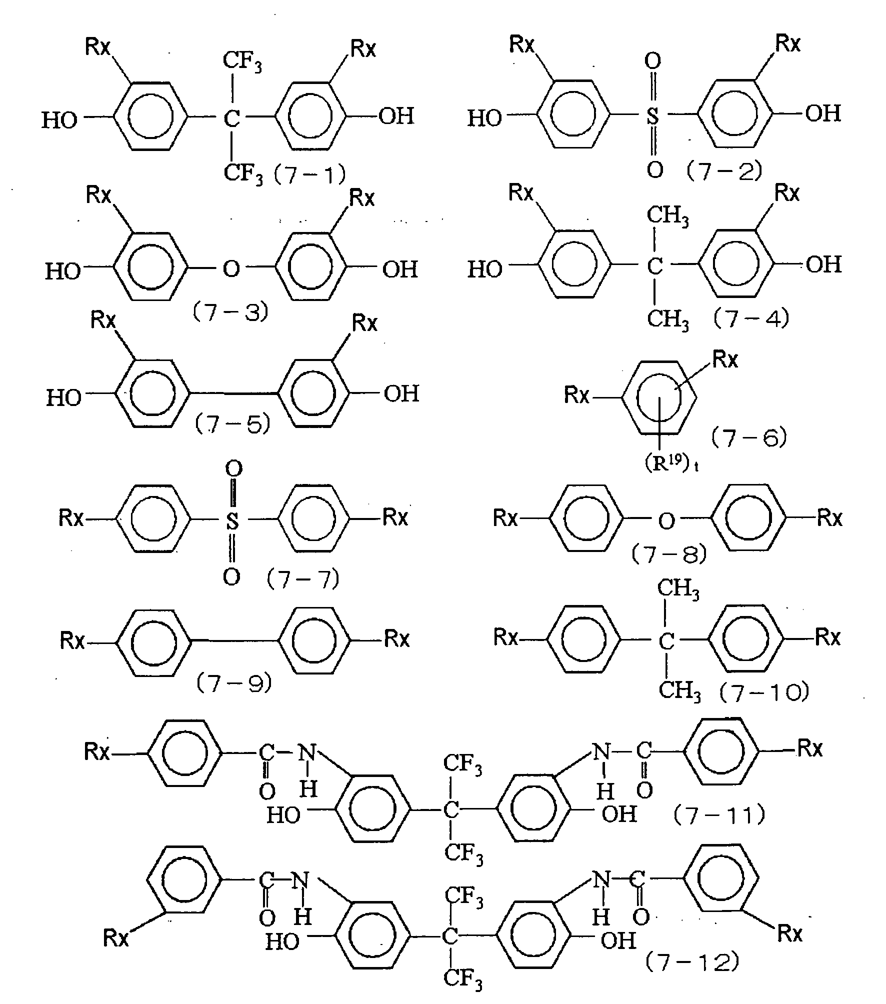

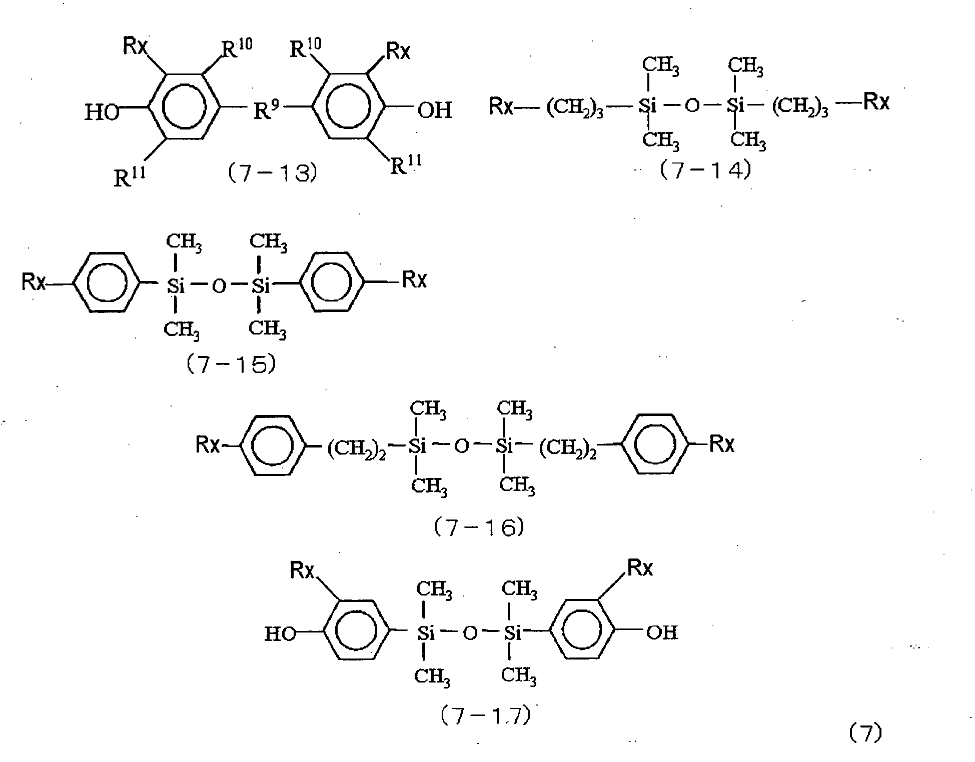

wherein R¹⁹s, which may be the same or different, represent one selected from the group consisting of alkyl, alkyl ester and halogen; t is an integer of 0 to 2; R⁹ is an organic group selected from the group consisting of alkylene, substituted alkylene, -O-, -S-, -SO₂-, -CO-, -NHCO- and a single bond; R¹⁰s, which may be the same or different, is alkyl group, alkoxy group, acyloxy group or cycloalkyl group; and R¹¹s, which may be the same ordifferent, is hydrogen, alkyl group, alkoxy group, acyloxy group or cycloalkyl group.

Particularly preferred are those represented by formulas (2) and (3) in the light of a positive photosensitive resin composition having excellent patterning properties and its cured film having excellent physical properties. These can be used alone or in combination of two or more.

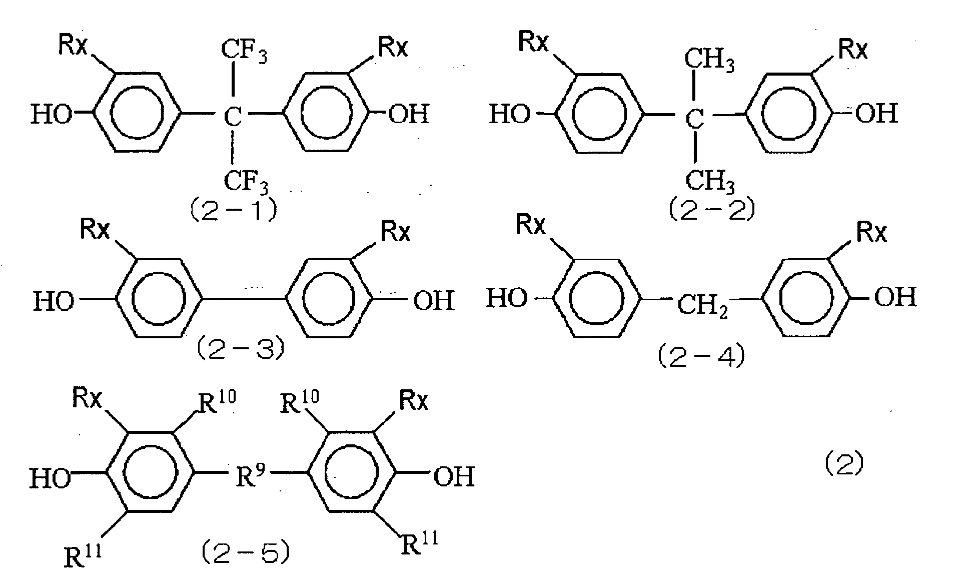

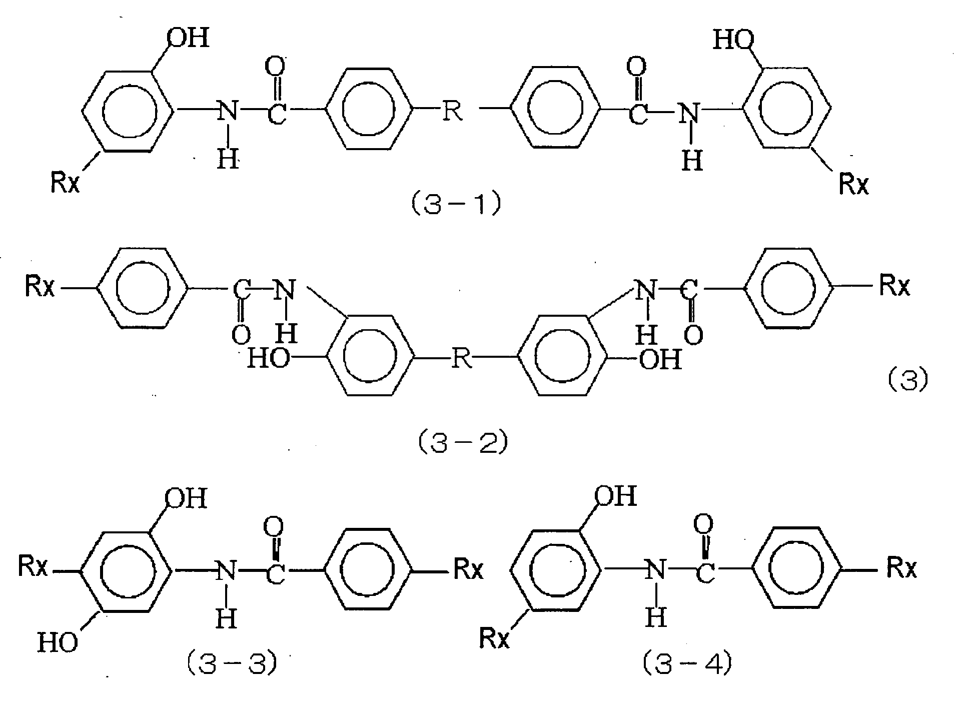

wherein Rx indicates bonding to NH; and R is -C(CH₃)₂-, -SO₂-, -C(CF₃)₂- or a single bond.

Examples of Y in a polyamide resin represented by general formula (1) include, but not limited to, those represented by formula (8):

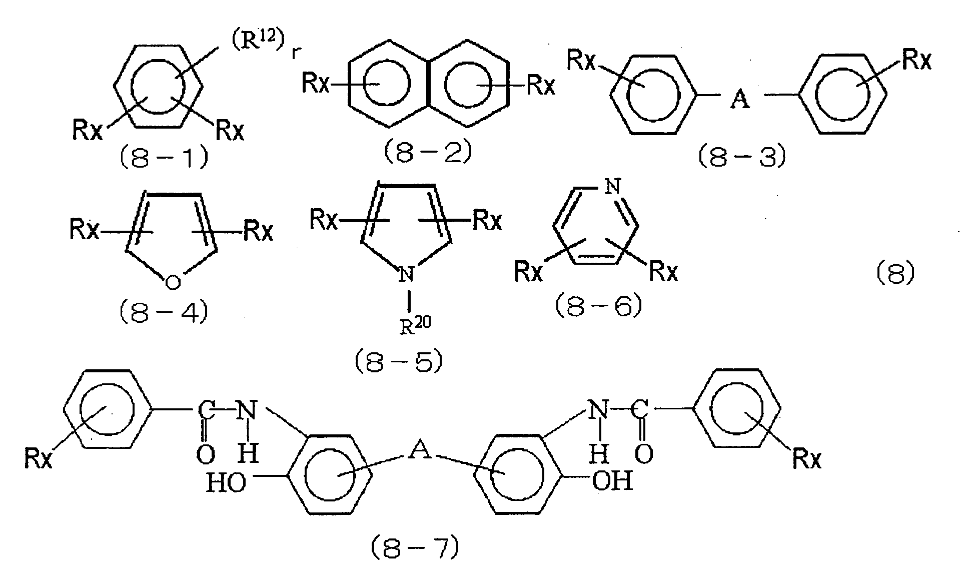

wherein Rx indicates bonding to C=O; A is -CH₂-, -C(CH₃)₂-, -O-, -S-, -SO₂-, -CO-, -NHCO-, -C(CF₃)₂- or a single bond; R¹²s, which may be the same or different, represent one selected from the group consisting alkyl, alkyl ester, alkyl ether, benzyl ether and halogen; R²⁰ represents one selected from the group consisting of hydrogen, alkyl, alkyl ester and halogen; and r is an integer of 0 to 2.

Among these, preferred are those represented by formula (4) in the light of a positive photosensitive resin composition having excellent patterning properties and its cured film having excellent physical properties. These may be used alone or in combination of two or more.

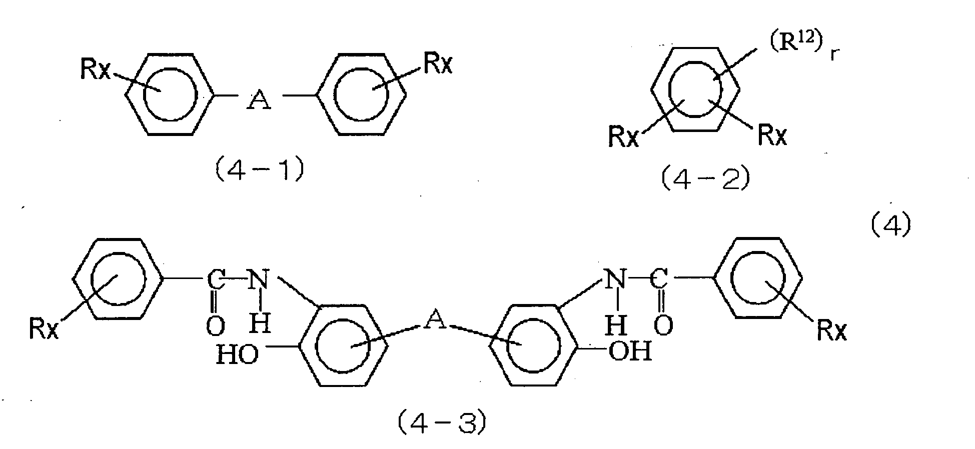

wherein Rx indicates bonding to C=O; A is -CH₂-, -C(CH₃)₂-, -O-, -S-, -SO₂-, -CO-, -NHCO-, -C(CF₃)₂- or a single bond; and R¹²s, which may be the same or different, represent one selected from the group consisting of alkyl, alkyl ester, alkyl ether, benzyl ether and halogen.

Among these, preferred are those represented by formula (a) in the light of a positive photosensitive resin composition having excellent patterning properties and its cured film having excellent physical properties:

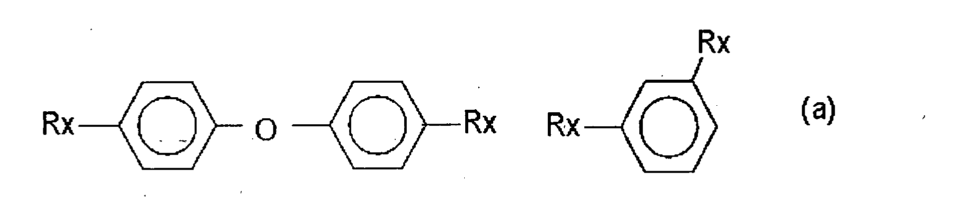

wherein Rx indicates bonding to C=O.

For the polyamide resin represented by general formula (1), the terminal of the polyamide resin can be sealed in the light of improvement of storage stability of a positive photosensitive resin composition; there can be introduced, but not limited to, a derivative containing an aliphatic group or a cyclic compound group having at least one of an alkenyl group or an alkynyl group as an acid derivative or an amine derivative to the terminal of the polyamide resin.

Specifically, a compound selected from, for example, a diamine, bis(aminophenol) and 2,4-diaminophenol having a structure of X can be reacted with a compound selected from, for example, tetracarboxylic anhydride, trimellitic anhydride, a dicarboxylic acid or dicarboxylic dichloride, a dicarboxylic acid derivative, hydroxydicarboxylic acid and a hydroxydicarboxylic acid derivative having a structure of Y, an amino group located at a terminal of the polyamide resin can be then capped as an amide using an acid derivative containing an aliphatic group or a cyclic compound group having at least one of alkenyl group or alkynyl group.
Examples of this end-capping functional group for a polyamide resin include those represented by formulas (9) and (10) :

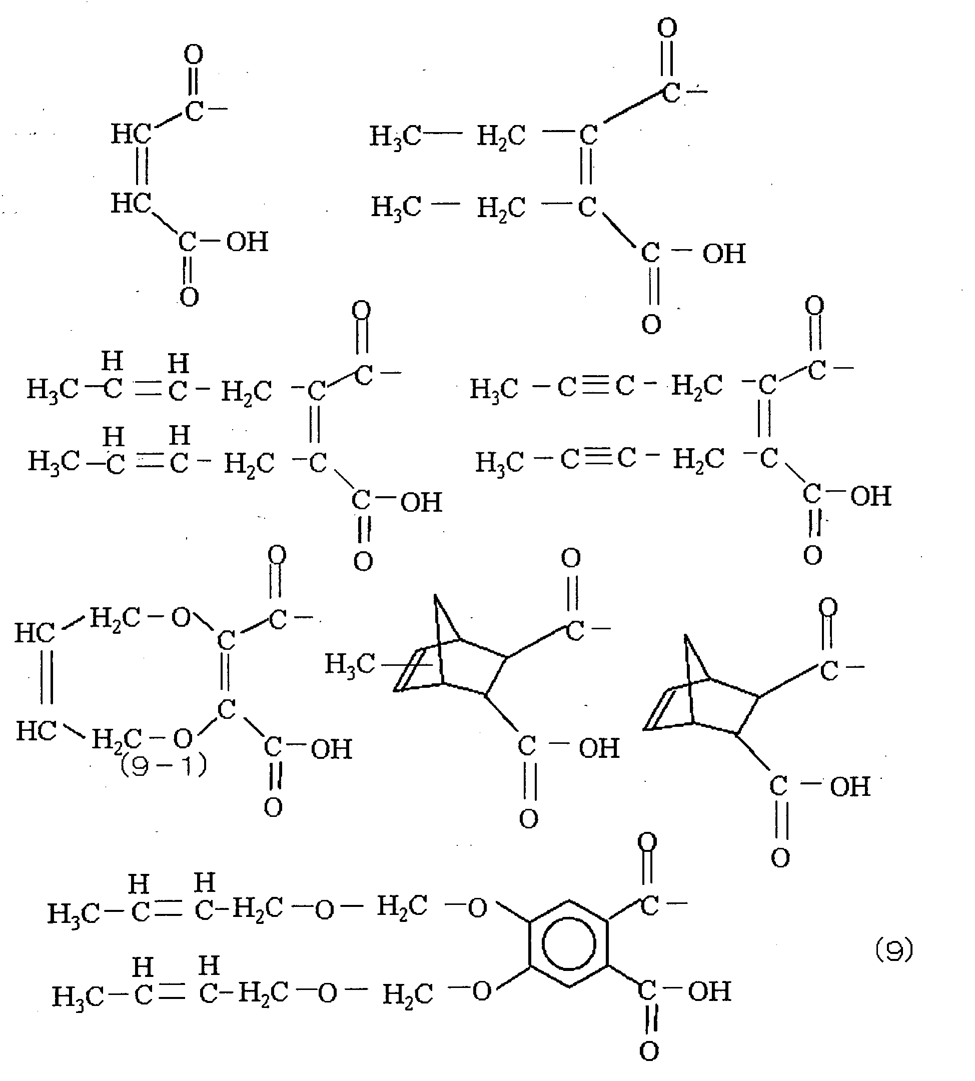

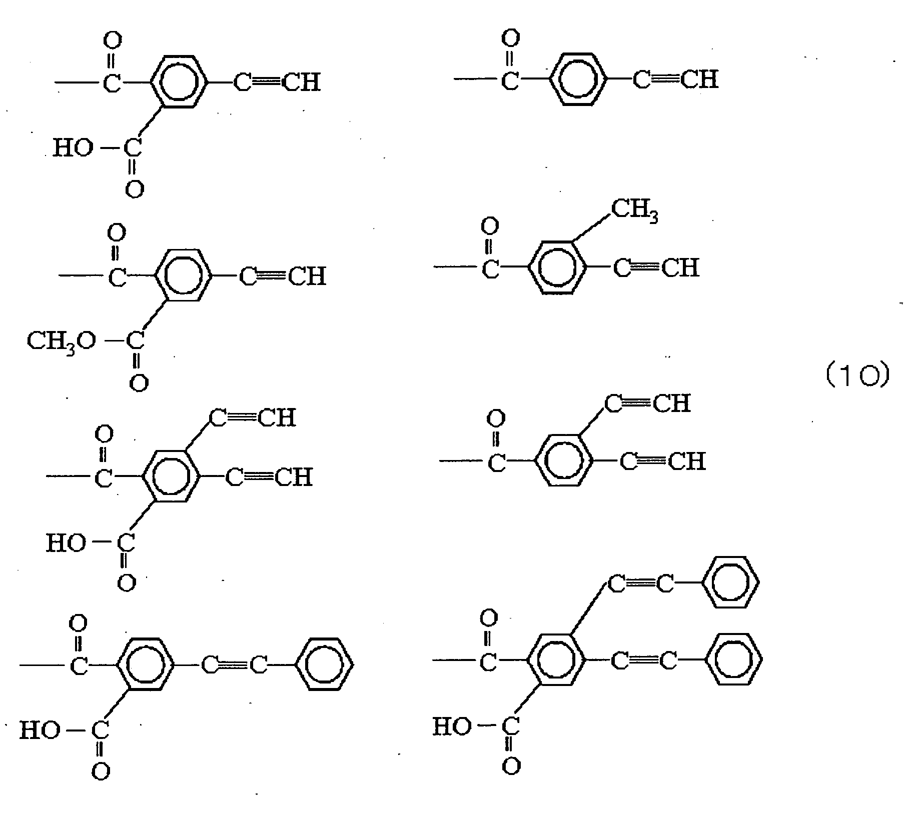

Among these, particularly preferred is a functional group represented by formula (11). These may be used alone or in combination of two or more. Without being restricted to the above method, the end acid group in the polyamide resin can be capped as an amide using an amine derivative containing an aliphatic group or a cyclic compound group having at least one of an alkenyl group or alkynyl group.

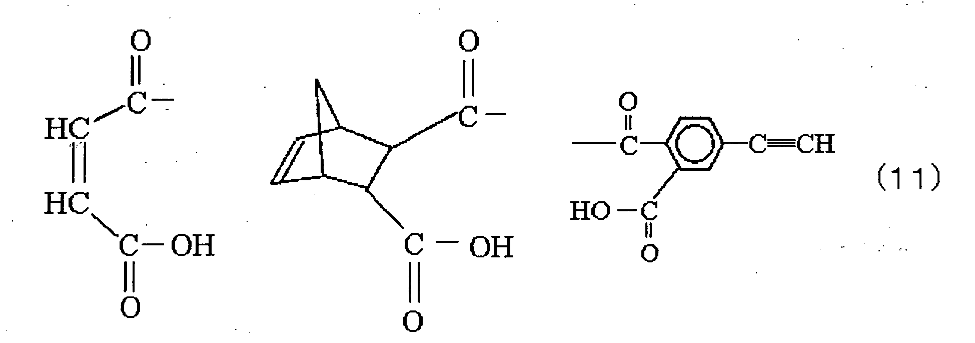

A photosensitizing agent (B) in the present invention is a compound having a 1,2-benzoquinone diazide or 1,2-naphthoquinone diazide structure, which is well-known from US patent Nos. 2,772,975, 2,797,213 and 3,669,658.
Examples may include compounds represented by formulas (12) to (18):

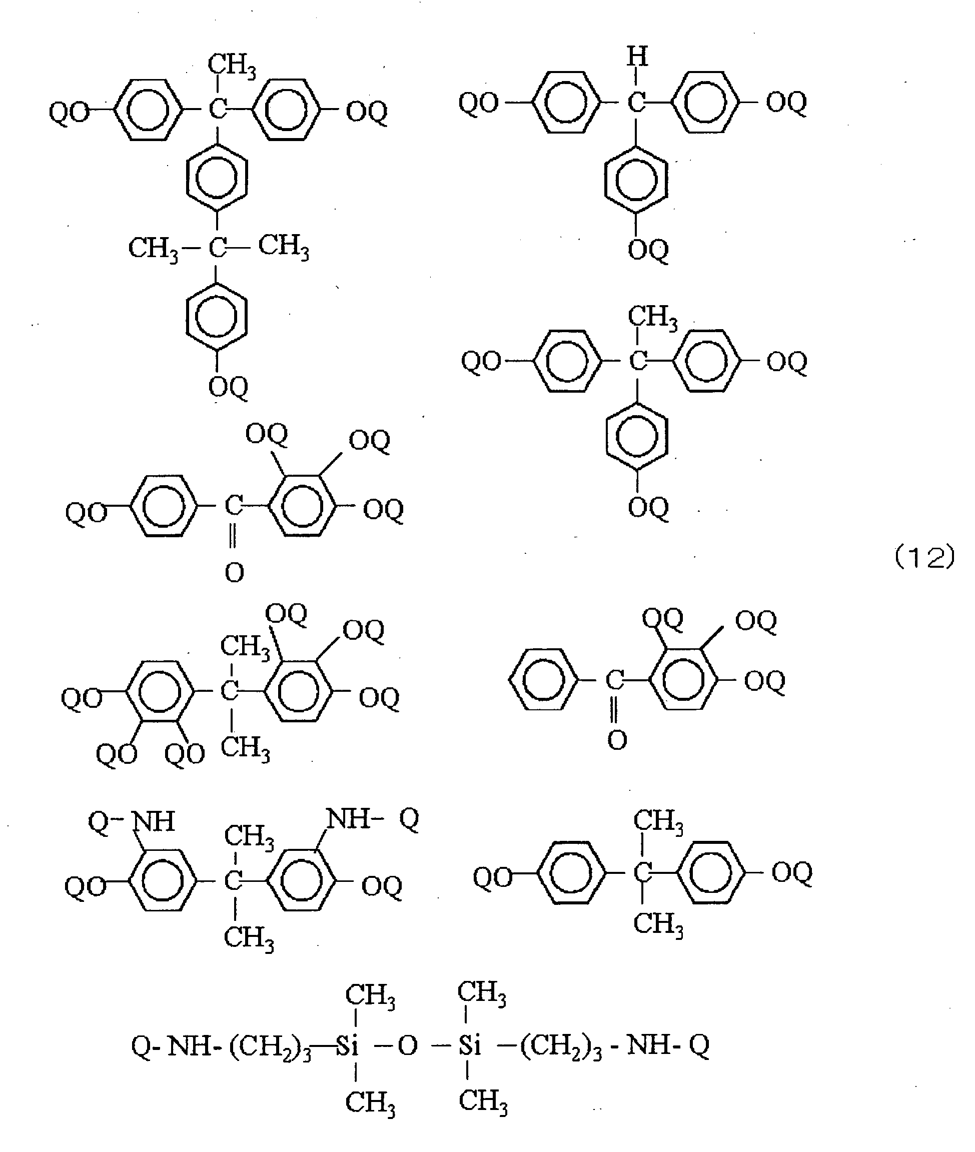

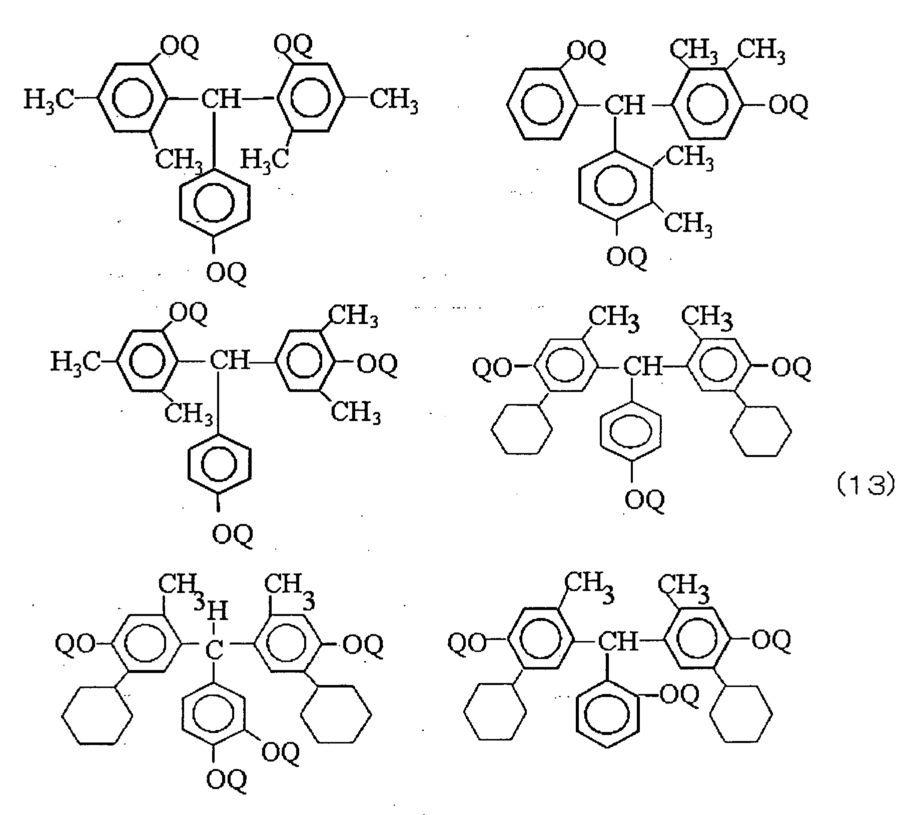

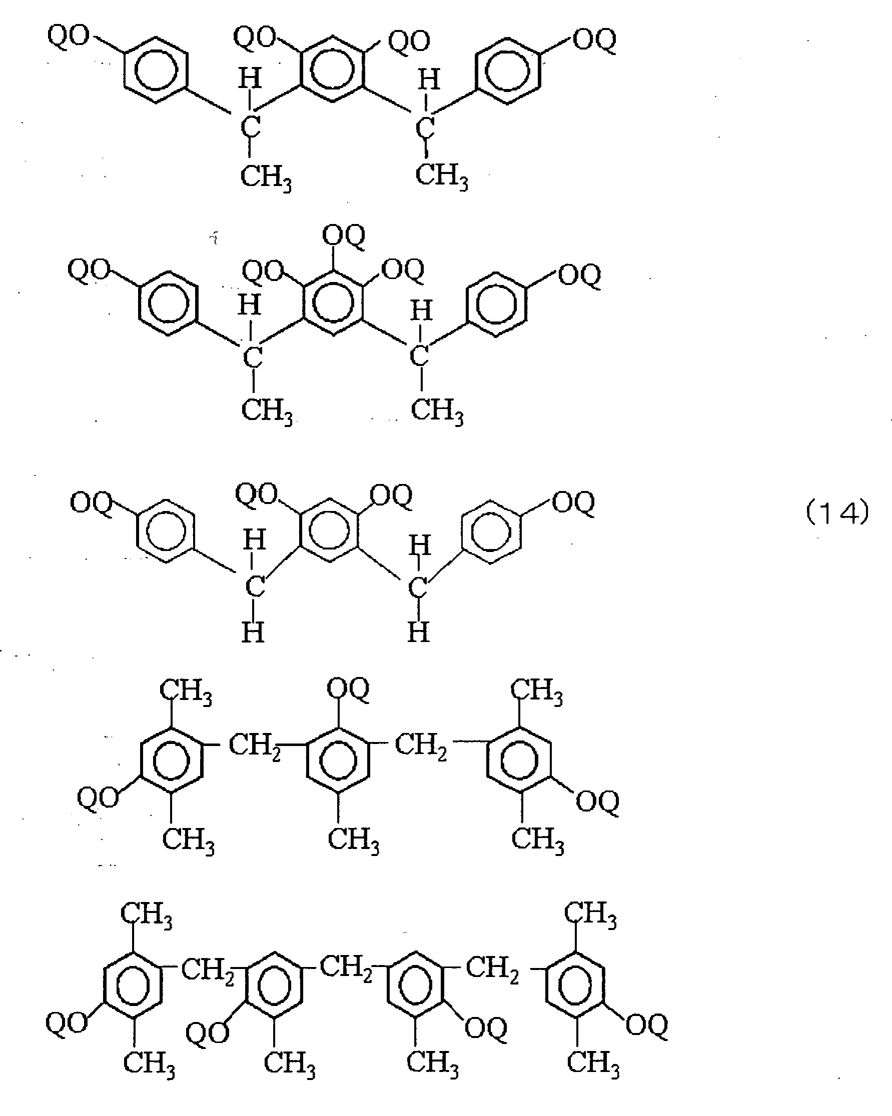

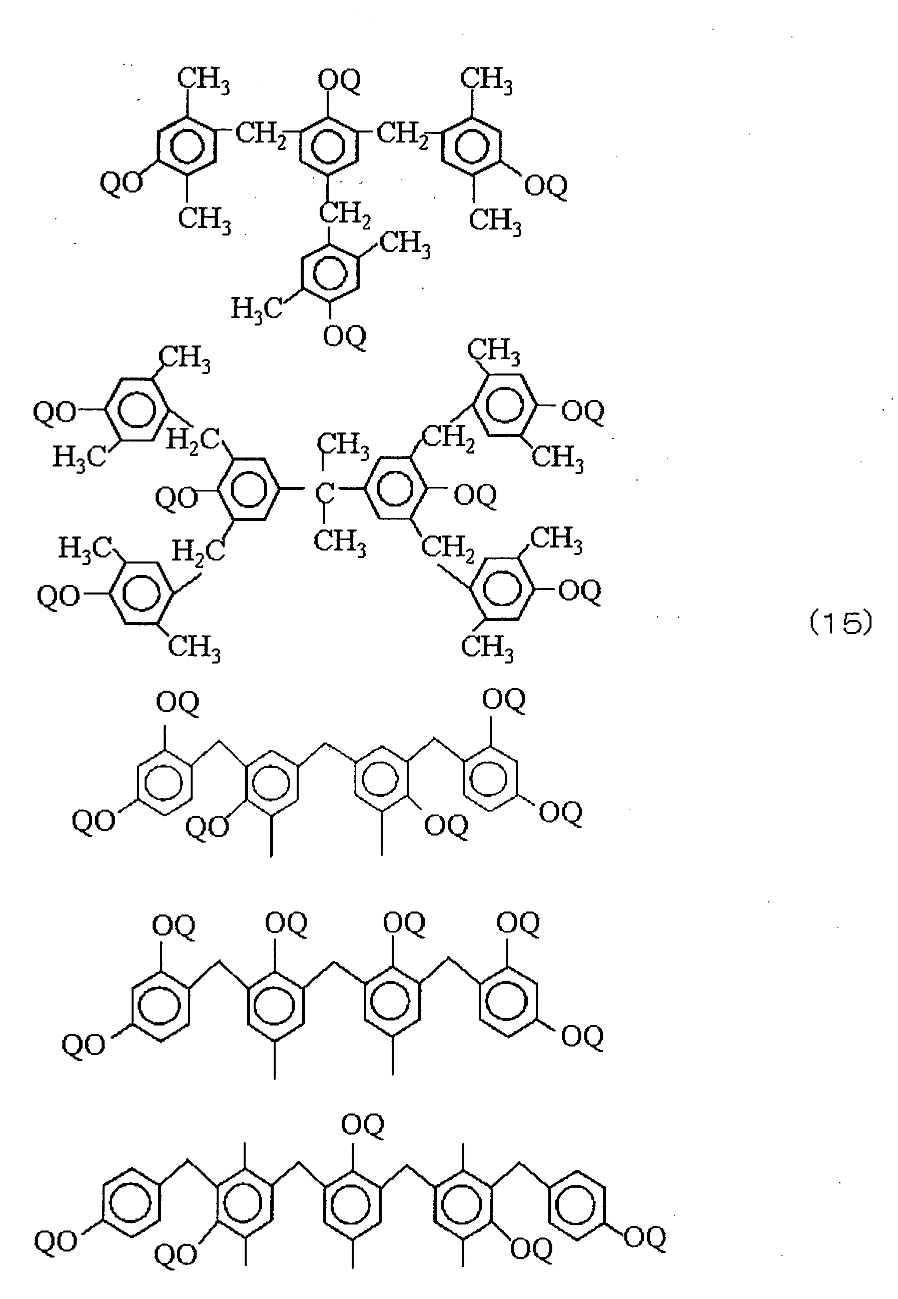

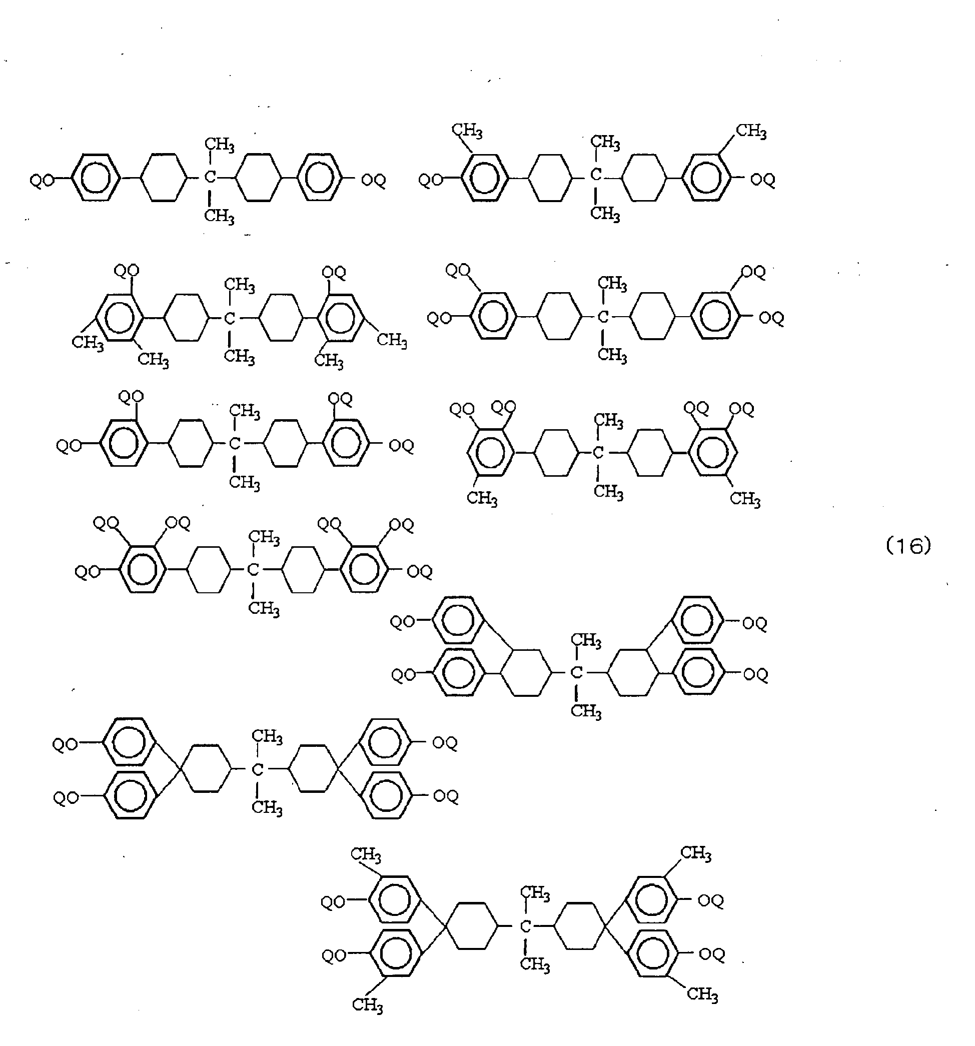

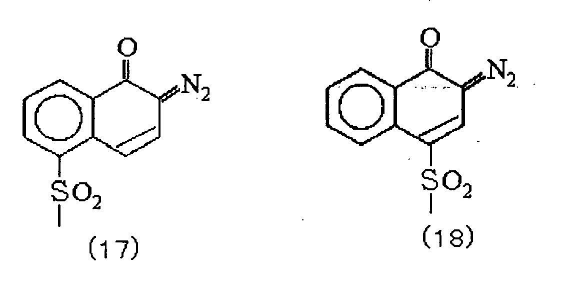

wherein Q is selected from hydrogen and groups represented by formulas (17) and (18). At least one of Qs in each compound is represented by formula (17) or (18). These may be used alone or in combination of two or more.

The amount of a photosensitizing agent (B) in the present invention is 10 to 40 parts by weight, preferably 10 to 30 parts by weight to 100 parts by weight of an alkali-soluble resin (A). The amount of a photosensitizing agent (B) to an alkali-soluble resin (A) also significantly influences on occurrence a scum in an open area, and if the amount is more than 40 parts by weight, solubility of a whole positive photosensitive resin composition in an alkaline developer is reduced, leading to increase in scum occurrence. If the amount is less than 10 parts by weight, the sensitivity of the positive photosensitive resin composition is reduced, so that an exposure time must be longer, leading to a reduced throughput.

In a positive photosensitive resin composition of the present invention, a compatibility of a prevention of a scum occurrence after development process and high sensitivity is possible by combining the use of an alkali-soluble resin (A) containing an ingredient having a molecular weight of 80,000 or more in 0.5 % or less and the use of a photosensitizing agent (B) in 10 to 40 parts by weight to 100 parts by weight of the alkali-soluble resin (A) When using an alkali-soluble resin (A) containing an ingredient having a molecular weight of 80,000 or more in 0.5 % or more, suitable sensitivity may be ensured, but a scum after development cannot be prevented even when the amount of the photosensitizing agent (B) is adjusted.
On the other hand, even when using an alkali-soluble resin (A) containing an ingredient having a molecular weight of 80, 000 or more in 0.5 % or less, a photosensitizing agent (B) in less than 10 parts by weight causes reduced sensitivity, leading to increase in an exposure time. When the amount of a photosensitizing agent (B) is more than 40 parts by weight, good sensitivity can be ensured while a scum after development cannot be prevented.

A positive photosensitive resin composition of the present invention may contain, as necessary, additives such as a leveling agent and a silane coupling agent.

After adding these ingredients to a positive photosensitive resin composition of the present invention in a solvent, the resulting varnish can be used. Examples of the solvent include, but not limited to, N-methyl-2-pyrrolidone, γ-butyrolactone, N,N-dimethylacetamide, dimethyl sulfoxide, diethyleneglycol dimethyl ether, diethyleneglycol diethyl ether, diethyleneglycol dibutyl ether, propyleneglycol monomethyl ether, dipropyleneglycol monomethyl ether, propyleneglycol monomethyl ether acetate, methyl lactate, ethyl lactate, butyl lactate, methyl-1,3-butyleneglycol acetate, 1,3-butyleneglycol-3-monomethyl ether, methy-1 pyruvate, ethyl pyruvate and methyl-3-methoxypropionate, which may be used alone or in combination.

There will be described a method for using of a positive photosensitive resin composition of the present invention.
First, a positive photosensitive resin composition is coated on a suitable support such as a silicon wafer, a ceramic substrate and an aluminum substrate for instance. For a semiconductor device, it is coated in such an amount so that a final film thickness after curing becomes 0.1 to 30 µm. If the film thickness is less than the lower limit, the film cannot sufficiently function as a protective surface film for a semiconductor element, and if the thickness is more than the upper limit, a fine processing pattern cannot be obtained and furthermore, processing takes more time, leading to throughput reduction. A method for coating includes, for example, by spin coating using a spinner, spray coating using a spray coater, immersion, printing or roll coating. Secondary, the coating film is dried by pre-baking at 60 to 130 °C to form a composition layer and thereafter irradiated with an actinic rays in the desired pattern form through a mask (exposure). The part irradiated with actinic rays is removed by a developing process (described later), while a part shielded by a mask pattern from actinic rays is not removed and left as a relief pattern. Examples of actinic rays which can be used include X-ray, electron beam, ultraviolet ray and visible light, preferably having a wavelength of 200 to 500 nm.

Next, the exposed area is removed by dissolution in a developer to provide a relief pattern. A scum in an open area is prevented in the present invention because the positive photosensitive resin contains an alkali-soluble resin (A) containing a macromolecular component having a molecular weight of 80,000 or more in an amount of 0.5 % or less and is highly soluble in a developer.

In terms of a development mechanism of this positive photosensitive resin composition, in an unexposed area, a photosensitizing agent (B) such as a diazoquinone compound interacts with an alkali-soluble resin (A) such as a polyamide resin to make a dissolution inhibition effect, and thus it becomes difficult to dissolve in a developer. On the other hand, in an exposed area, the photosensitizing agent (B) such as a diazoquinone compound undergoes chemical transformation to become readily-soluble in an alkaline developer. By dissolving and removing the exposed area utilizing such a solubility difference between the exposed area and the unexposed area, a relief pattern consisting of the unexposed area can be formed.

Examples of the developer which can be suitably used include, but not limited to, an aqueous solution of an alkali including inorganic alkali compounds such as sodium hydroxide, potassium hydroxide, sodium carbonate, sodium silicate, sodium metasilicate and aqueous ammonia; primary amines such as ethylamine and n-propylamine; secondary amines such as diethylamine and di-n-propylamine; tertiary amines such as triethylamine and methyldiethylamine; alcoholamines such as dimethylethanolamine and triethanolamine; and quaternary ammonium, salts such as tetramethylammonium hydroxide and tetraethylammonium hydroxide, and an aqueous solution prepared by adding a water-soluble organic solvent including an alcohol such as methanol and ethanol or a surfactant in such an alkaline aqueous solution. Development can be conducted by an appropriate method such as spraying, paddling, immersion and sonication.

Then, the relief pattern formed after development is rinsed. A rinse agent may be, but not limited to, distilled water.

Next, the relief pattern is heated for forming an oxazole ring and/or imide ring to provide a final pattern which is significantly heat resistant. Heating may be conducted either at a high or low temperature, and a temperature in high-temperature heating is preferably 280 °C to 380 °C, more preferably 290 °C to 350 °C. A temperature in low-temperature heating is preferably 150 °C to 280 °C, more preferably 180 °C to 260 °C.

### 2. Cured film, protective film, insulating film, semiconductor device and display device

There will be described a cured film from a positive photosensitive resin composition of the present invention. A cured film as a cured product of a positive photosensitive resin composition is useful, in addition to semiconductor device applications such as a semiconductor element, in display device applications such as a TFT liquid crystal and an organic EL, an interlayer insulating film in a multilayer circuit and a cover coat for a flexible copper-clad plate, a solder resist film and a liquid crystal oriented film.

A thickness of the cured film is, but not limited to, preferably 0.1 to 50 µm, particularly preferably 1 to 30 µm. A thickness within the range, in particular, results in good balance between processability and physical properties of a cured film.

Examples of a semiconductor device application may include passivation film composed of a cured film of the positive photosensitive resin composition over a semiconductor element; a protective film such as a buffer coat film composed of a cured film of the positive photosensitive resin composition formed over a passivation film; an insulating film such as an interlayer insulating film composed of a cured film of the positive photosensitive resin composition formed over a circuit on a semiconductor element, an α-ray shielding film, a planarizing film, a protrusion (resin post) and a septum.

Examples of a display device application may include a protective film composed of a cured film of the positive photosensitive resin composition formed over a display element; an insulating film or planarizing film for, for example, a TFT element or a color filter; a protrusion for, for example, an MVA type liquid-crystal display device; and a barrier rib for, for example, a cathode in an organic EL element. It is used as in a semiconductor device application; specifically, a patterned positive photosensitive resin composition layer is formed over a substrate on which a display element or a color filter is formed, as described above. Although a display device application, particularly an insulating film or planarizing film application, requires higher transparency, the step of post-exposure can be introduced before curing the positive photosensitive resin composition layer, to provide a highly transparent resin layer, which is further preferable for practical purposes.

### EXAMPLES

There will be detailed the present invention with reference to, but not limited to, Examples and Comparable Examples.

### [Example 1]

### [Synthesis of an alkali-soluble resin]

In a four-necked separable flask equipped with a thermometer, a stirrer, a material inlet port and a dry nitrogen gas inlet tube were placed a dicarboxylic acid derivative mixture (0.016 mol) obtained by reacting 4.13 g of diphenylether -4,4'-dicarboxylic acid (0.016 mol) and 4.32 g of 1-hydroxy-1,2,3-benzotriazole (0.032 mol) and 7.33 g of hexafluoro-2,2-bis(3-amino-4-hydroxyphenyl)propane (0.020 mol), and then 57.0 g of N-methyl-2-pyrrolidone was added to obtain a solution. Then, the mixture was reacted at 75 °C for 12 hours using an oil bath. To the mixture was added 1.31 g of 5-norbornene -2,3-dicarboxylic anhydride (0.008 mol) dissolved in 7 g of N-methyl-2-pyrrolidone, and the mixture was stirred for further 12 hours to complete the reaction. After the reaction mixture was filtered, the filtrate was poured into a solution of water/methanol = 3/1 (by volume) while maintaining a solution temperature at 22 °C, and a precipitate was collected by filtration, thoroughly washed with water and then dried under vacuum to give a polyamide resin (A-1) as a desired alkali-soluble resin.

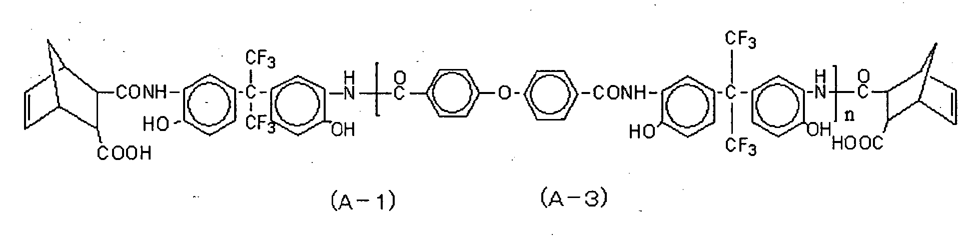

wherein n is 15 to 20.

### [Determination of a molecular weight of a polyamide resin]

As determined by gel permeation chromatography, a molecular weight of the polyamide resin (A-1) obtained was 13000 as a weight-average molecular weight and a content of an ingredient having a molecular weight of 80, 000 or more was 0.04 %.

### [Preparation of a positive photosensitive resin composition]

In 20 g of γ-butyrolactone were dissolved 10 g of the polyamide resin (A-1) obtained and 2 g of a photosensitive diazoquinone (B-1) having the following structure, and the mixture was filtered by a 0.2 µm fluororesin filter, to give a positive photosensitive resin composition.

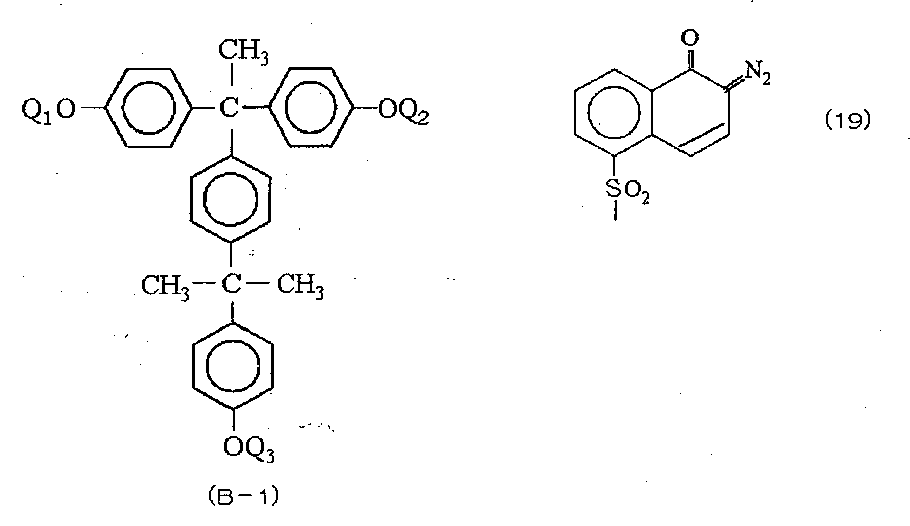

wherein 75 % of Q₁, Q₂ and Q₃ is the group of formula (19) and 25 % is hydrogen.

### [Formation of a relief pattern]

Using a spin coater, on a 8 inch silicon wafer was applied the positive photosensitive resin composition obtained as described above, which was then dried on a hot plate at 120 °C for 4 min to give a coating film with a thickness of about 10 µm. The coating film formed was exposed with various exposure amount from 200 mJ/cm² increased by 10 mJ/cm² each through a mask from Toppan Printing Co., Ltd. (Test Chart No.1: having a line pattern with a width of 0.88 to 50 µm and a space pattern) using an i-line stepper NSR-4425i from Nikon Corporation. Next, the film was developed in a 2.38 % aqueous solution of tetramethylammonium hydroxide while adjusting a developing time to 40 sec such that a film thickness reduction in an unexposed area was to be 1.0 µm. From observation of the pattern, it was confirmed that a pattern was successfully opened at an exposure amount of 350 mJ/cm² without scum generation.

### [Example 2]

### [Synthesis of an alkali-soluble resin]

In a four-necked separable flask equipped with a thermometer, a stirrer, a material inlet port and a dry nitrogen gas inlet tube were placed 17.06 g of 4,4'-oxydiphthalic anhydride (0.055 mol), 8.15 g of 2-methyl-2-propanol (0.110 mol) and 10.9 g of pyridine (0.138 mol), and then 150 g of N-methyl-2-pyrrolidone was added to obtain a solution. To the reaction solution were added dropwise 14.9 g of 1-hydroxy-1,2,3-benzotriazole (0.110 mol) and 30 g of N-methyl-2-pyrrolidone together, and then 22.7 g dicyclohexylcarbodiimide (0.110 mol) and 50 g of N-methyl-2-pyrrolidone together, and the mixture was reacted at room temperature overnight. Next, to the reaction solution were added 27.1 g of a dicarboxylic acid derivative (activated ester) (0.055 mol) prepared by reacting 1 mol of diphenyl ether-4,4'-dicarboxylic acid and 2 mol of 1-hydroxy-1,2,3-benzotriazole and 44.7 g of hexafluoro-2,2-bis(3-amino-4-hydroxyphenyl)propane (0.122 mol) with 70 g of N-methyl-2-pyrrolidone, and the mixture was stirred at room temperature for 2 hours. Then, the mixture was reacted at 75 °C for 12 hours using an oil bath. Next, to the mixture was added 3.94 g of 5-norbornene -2,3-dicarboxylic anhydride (0.024 mol) dissolved in 20 g of N-methyl-2-pyrrolidone, and the mixture was stirred for further 12 hours to complete the reaction. Then, precipitation and purification were conducted as described in Example 1, to synthesize a polyamide resin (A-2) as a desired alkali-soluble resin.

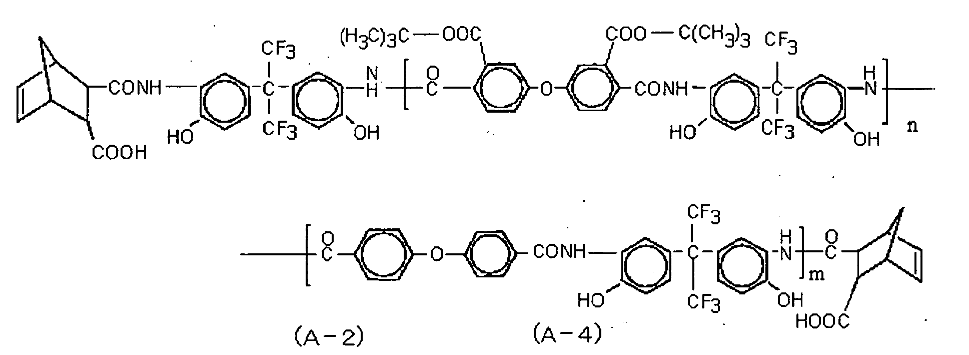

wherein n and m, which are substantially equal, are 7 to 10.

### [Determination of a molecular weight of a polyamide resin]

As determined as described in Example 1, the polyamide resin (A-2) thus prepared had a weight-average molecular weight of 12,000 with a content of an ingredient having a molecular weight of 80,000 or more of 0.10 %.

### [Preparation of a positive photosensitive resin composition]

In 20 g of γ-butyrolactone were dissolved 10 g of the polyamide resin (A-2) and 2.0 g of a photosensitive diazoquinone (B-1) having the following structure, and the mixture was filtered using a 0.2 µm fluororesin filter, to give a positive photosensitive resin composition.

### [Formation of a relief pattern]

Subsequently, a relief pattern was formed as described in Example 1. A developing time until a film thickness was reduced by 1.0 µm was 30 sec. Sensitivity was 380 mJ/cm² and it was confirmed that a pattern was successfully opened without scum generation.

### [Example 3]

### [Preparation of a positive photosensitive resin composition]

A process was conducted as described in Example 1, substituting 1.5 g of a photosensitive diazoquinone (B-2) having the following structure for 2.0 g of the photosensitive diazoquinone (B-1) in preparation of a positive photosensitive resin.

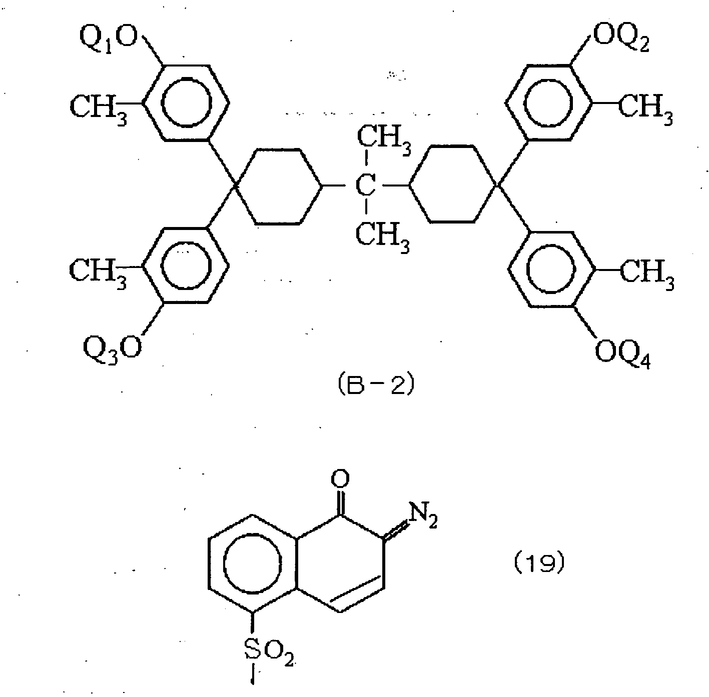

wherein 87.5 % of Q₁, Q₂ and Q₃ is the group of formula (19) and 12.5 % is hydrogen.

### [Formation of a relief pattern]

Subsequently, a relief pattern was formed as described in Example 1. A developing time until a film thickness was reduced by 1.0 µm was 30 sec. Sensitivity was 400 mJ/cm² and it was confirmed that a pattern was successfully opened without scum generation.

### [Example 4]

### [Preparation of a positive photosensitive resin composition]

A process was conducted as described in Example 1, using 1.2 g of the photosensitive diazoquinone (B-1) instead of 2.0 g in preparation of a positive photosensitive resin.

### [Formation of a relief pattern]

Subsequently, a relief pattern was formed as described in Example 1. A developing time until a film thickness was reduced by 1.0 µm was 15 sec. Sensitivity was 500 mJ/cm² and it was confirmed that a pattern was successfully opened without scum generation.

### [Comparable Example 1]

### Synthesis of an alkali-soluble resin

In a four-necked separable flask equipped with a thermometer, a stirrer, a material inlet port and a dry nitrogen gas inlet tube were placed a dicarboxylic acid derivative mixture (0.016 mol) obtained by reacting 4.13 g of diphenyl ether -4,4'-dicarboxylic acid (0.016 mol) and 4.32 g of 1-hydroxy-1,2,3-benzotriazole (0.032 mol) and 7.33 g of hexafluoro-2,2-bis(3-amino-4-hydroxyphenyl)propane (0.020 mol), and then 57.0 g of N-methyl-2-pyrrolidone was added to obtain a solution. Then, the mixture was reacted at 90 °C for 12 hours using an oil bath. To the mixture was added 1.31 g of 5-norbornene-2,3-dicarboxylic anhydride (0.008 mol) dissolved in 7 g of N-methyl-2-pyrrolidone, and the mixture was stirred for further 12 hours to complete the reaction. After the reaction mixture was filtered, the filtrate was poured into a solution of water/methanol = 3/1 (by volume) while maintaining a solution temperature at 22 °C, and a precipitate was collected by filtration, thoroughly washed with water and then dried under vacuum to give a polyamide resin (A-3) as a desired alkali-soluble resin.

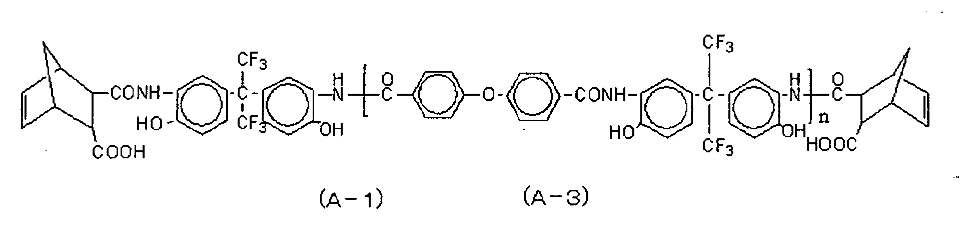

wherein n is 15 to 20.

### [Determination of a molecular weight of a polyamide resin]

As determined as described in Example 1, a molecular weight of the polyamide resin (A-3) obtained was 13000 as a weight-average molecular weight and a content of an ingredient having a molecular weight of 80,000 or more was 0.65 %.

### [Preparation of a positive photosensitive resin composition]

In 20 g of γ-butyrolactone were dissolved 10 g of the polyamide resin (A-3) obtained and 2.0 g of a photosensitive diazoquinone (B-1) having the following structure, and the mixture was filtered by a 0.2 µm fluororesin filter, to give a positive photosensitive resin composition.

### [Formation of a relief pattern]

Subsequently, a relief pattern was formed as described in Example 1. A developing time until a film thickness was reduced by 1.0 µm was 40 sec. Sensitivity was 360 mJ/cm² and a scum was generated in a pattern opening.

### [Comparable Example 2]

### [Synthesis of an alkali-soluble resin]

In a four-necked separable flask equipped with a thermometer, a stirrer, a material inlet port and a dry nitrogen gas inlet tube were placed 17.06 g of 4,4'-oxydiphthalic anhydride (0.055 mol), 8.15 g of 2-methyl-2-propanol (0.110 mol) and 10.9 g of pyridine (0.138 mol), and then 150 g of N-methyl-2-pyrrolidone was added to obtain a solution. To the reaction solution were added dropwise 14.9 g of 1-hydroxy-1,2,3-benzotriazole (0.110 mol) and 30 g of N-methyl-2-pyrrolidone together, and then 22.7 g dicyclohexylcarbodiimide (0.110 mol) and 50 g of N-methyl-2-pyrrolidone together, and the mixture was reacted at room temperature overnight. Next, to the reaction solution were added 27.1 g of a dicarboxylic acid derivative (activated ester) (0.055 mol) prepared by reacting 1 mol of diphenyl ether-4,4'-dicarboxylic acid and 2 mol of 1-hydroxy-1,2,3-benzotriazole and 44.7 g of hexafluoro-2,2-bis(3-amino-4-hydroxyphenyl)propane (0.122 mol) with 70 g of N-methyl-2-pyrrolidone, and the mixture was stirred at room temperature for 2 hours. Then, the mixture was reacted at 90 °C for 12 hours using an oil bath.
Next, to the mixture was added 3.94 g of 5-norbornene -2,3-dicarboxylic anhydride (0.024 mol) dissolved in 20 g of N-methyl-2-pyrrolidone, and the mixture was stirred for further 12 hours to complete the reaction. Then, precipitation and purification were conducted as described in Example 1, to synthesize a polyamide resin (A-4) as a desired alkali-soluble resin.

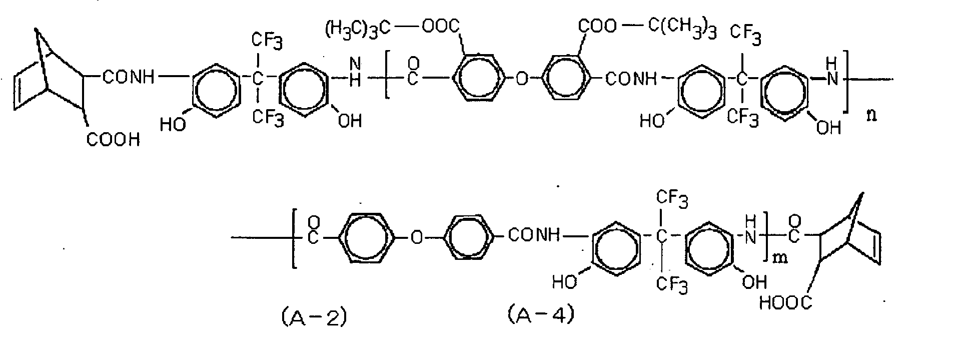

wherein n and m, which are substantially equal; are 7 to 10.

### [Preparation of a positive photosensitive resin composition]

In 20 g of γ-butyrolactone were dissolved 10 g of the polyamide resin (A-4) and 2.0 g of a photosensitive diazoquinone (B-1) having the following structure, and the mixture was filtered using a 0.2 µm fluororesin filter, to give a positive photosensitive resin composition.

### [Formation of a relief pattern]

Subsequently, a relief pattern was formed as described in Example 1. A developing time until a film thickness was reduced by 1.0 µm was 30 sec. Sensitivity was 360 mJ/cm² and a scum was generated in a pattern opening.

### [Comparable Example 3]

### [Preparation of a positive photosensitive resin composition]

A process was conducted as described in Example 1, using 4.5 g of the photosensitive diazoquinone (B-1) in preparation of a positive photosensitive resin.

### [Formation of a relief pattern]

Subsequently, a relief pattern was formed as described in Example 1. A developing time until a film thickness was reduced by 1.0 µm was 90 sec. Sensitivity was 180 mJ/cm² and a scum was generated in a pattern opening.

### [Comparable Example 4]

### [Preparation of a positive photosensitive resin composition]

A process was conducted as described in Example 1, using 0.5 g of the photosensitive diazoquinone (B-1) in preparation of a positive photosensitive resin.

### [Formation of a relief pattern]

Subsequently, a relief pattern was formed as described in Example 1. A developing time until a film thickness was reduced by 1.0 µm was 5 sec and a pattern was not opened.

### [Comparable Example 5]

### [Synthesis of an alkali-soluble resin]

In a four-necked separable flask equipped with a thermometer, a stirrer, a material inlet port and a dry nitrogen gas inlet tube were placed a dicarboxylic acid derivative mixture (0.016 mol) obtained by reacting 4.13 g of diphenyl ether -4,4'-dicarboxylic acid (0.016 mol) and 4.32 g of 1-hydroxy-1,2,3-benzotriazole (0.032 mol) and 7.33 g of hexafluoro-2,2-bis(3-amino-4-hydroxyphenyl)propane (0.020 mol), and then 57.0 g of N-methyl-2-pyrrolidone was added to obtain a solution. Then, the mixture was reacted at 75 °C for 12 hours using an oil bath. To the mixture was added 1.31 g of 5-norbornene -2,3-dicarboxylic anhydride (0.008 mol) dissolved in 7 g of N-methyl-2-pyrrolidone, and the mixture was stirred for further 12 hours to complete the reaction. After the reaction mixture was filtered, the filtrate was poured into a solution of water/methanol = 3/1 (by volume) while maintaining a solution temperature at 15 °C, and a precipitate was collected by filtration, thoroughly washed with water and then dried under vacuum to give a polyamide resin (A-5) as a desired alkali-soluble resin.

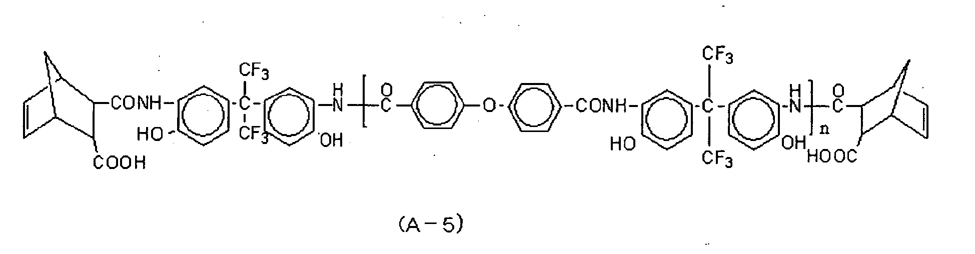

Table 1 shows the evaluation results obtained for Examples and Comparable Examples.

**Table 1**

| | | Alkali-soluble resin | | Content | | Properties | | | |
|---|---|---|---|---|---|---|---|---|---|
| | | weight-average molecular weight | Proportion of an ingredient having a molecular weight of 80,000 or more | (A) Alkali-soluble resin (g) | (B) Diazoquin one compound (g) | Devel oping time (s) | Film thickn ess reduct ion by develo pment (µm) | Sensit ivity (mJ/cm ²) | Scum |
| Example | 1 | 13000 | 0.04 | A-1(10) | B-1(2.0) | 40 | 1.0 | 350 | None |
| | 2 | 12000 | 0.10 | A-2(10) | B-1(2.0) | 30 | 1.0 | 380 | None |
| | 3 | 13000 | 0.04 | A-1(10) | B-2(1.5) | 30 | 1.0 | 400 | None |
| | 4 | 13000 | 0.04 | A-1(10) | B-1(1.2) | 15 | 1.0 | 500 | None |
| Comparable Example | 1 | 13000 | 0.65 | A-3(10) | B-1(2.0) | 40 | 1.0 | 360 | Observed |
| | 2 | 12000 | 0.55 | A-4(10) | B-1(2.0) | 30 | 1.0 | 360 | Observed |
| | 3 | 13000 | 0.04 | A-1(10) | B-1(4.5) | 90 | 1.0 | 180 | Observed |
| | 4 | 13000 | 0.04 | A-1(10) | B-1(0.5) | 5 | 1.0 | - | Not opened |
| | 5 | 13000 | 0.60 | A-5(10) | B-1(2.0) | 40 | 1.0 | 350 | Observed |

The present invention can achieve both prevention of scum generation in an open area in a positive photosensitive resin composition and improvement in sensitivity, and can be suitably applied to, for example, a surface protective film in a semiconductor element, an interlayer insulating film or an insulating film in a display device.

This application claims a priority to Japanese Patent Application No. 2008-3913, whose disclosure is entirely incorporated herein by reference.

## Claims

1. A positive photosensitive resin composition comprising;
an alkali-soluble resin (A) containing an ingredient having a molecular weight of 80,000 or more in 0.5 % or less; and
a photosensitizing agent (B),
wherein the amount of said photosensitizing agent (B) is 10 parts by weight or more and 40 parts by weight or less to 100 parts by weight of said alkali-soluble resin (A).

2. The positive photosensitive resin composition as claimed in Claim 1, wherein said alkali-soluble resin (A) is a compound having a repeating unit represented by general formula (1) : 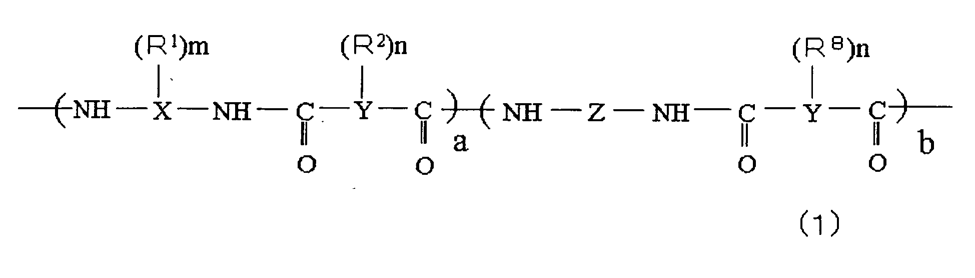 wherein X and Y are an organic group; a and b represents a molar percentage, and when a+b=100, a is 60 or more and 100 or less and b is 0 or more and 40 or less; R¹ is hydroxy group, -O-R³ or an organic group having 1 to 15 carbon atoms and when a plurality of R¹s exist, these may be the same or different; R² and R⁸ are hydroxy group, carboxyl group, -O-R³ or -COO-R³ and when a plurality of R²s and R⁸s exist, these may be the same or different; m is an integer of 0 to 4; n is an integer of 0 to 4; R³ is an organic group having 1 to 15 carbon atoms, provided that when there are no R¹s as hydroxy group, at least one of R²s and R⁸s must be carboxyl group and when there are no R²s nor R⁸s as carboxyl group, at least one of R¹s must be hydroxy group; Z is represented by -R⁴-Si(R⁶)(R⁷)-O-Si(R⁶)(R⁷)-R⁵- wherein R⁴ to R⁷ are an organic group.

3. The positive photosensitive resin composition as claimed in Claim 1 or 2, wherein said photosensitizing agent (B) is a diazonaphthoquinone compound.

4. The positive photosensitive resin composition as claimed in any of Claims 1 to 3, further comprising a compound (C) having phenolic hydroxy group.

5. The positive photosensitive resin composition as claimed in any of Claims 1 to 4, wherein X in general formula (1) contains a structure represented by formula (2): 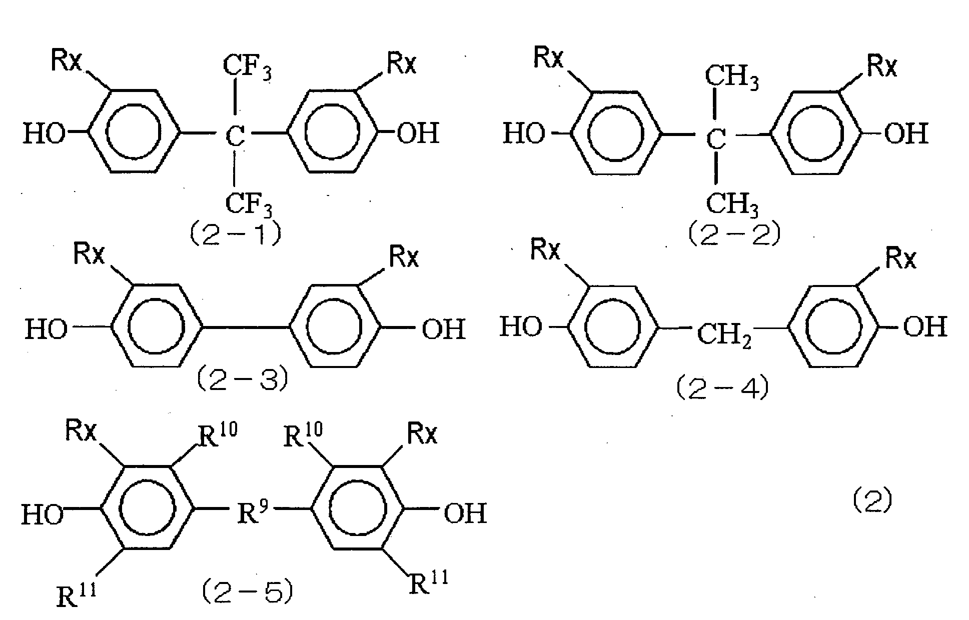 wherein Rx indicates bonding to NH; R⁹ is an organic group selected from the group consisting of alkylene, substituted alkylene, -O-, -S-, -SO₂-, -CO-, -NHCO- and a single bond; R¹⁰s, which may be the same or different, are alkyl group, alkoxy group, acyloxy group or cycloalkyl group; R¹¹s, which may be the same or different, is hydrogen, alkyl group, alkoxy group, acyloxy group or cycloalkyl group.

6. The positive photosensitive resin composition as claimed in any of Claims 1 to 4, wherein X in general formula (1) contains a structure represented by formula (3):

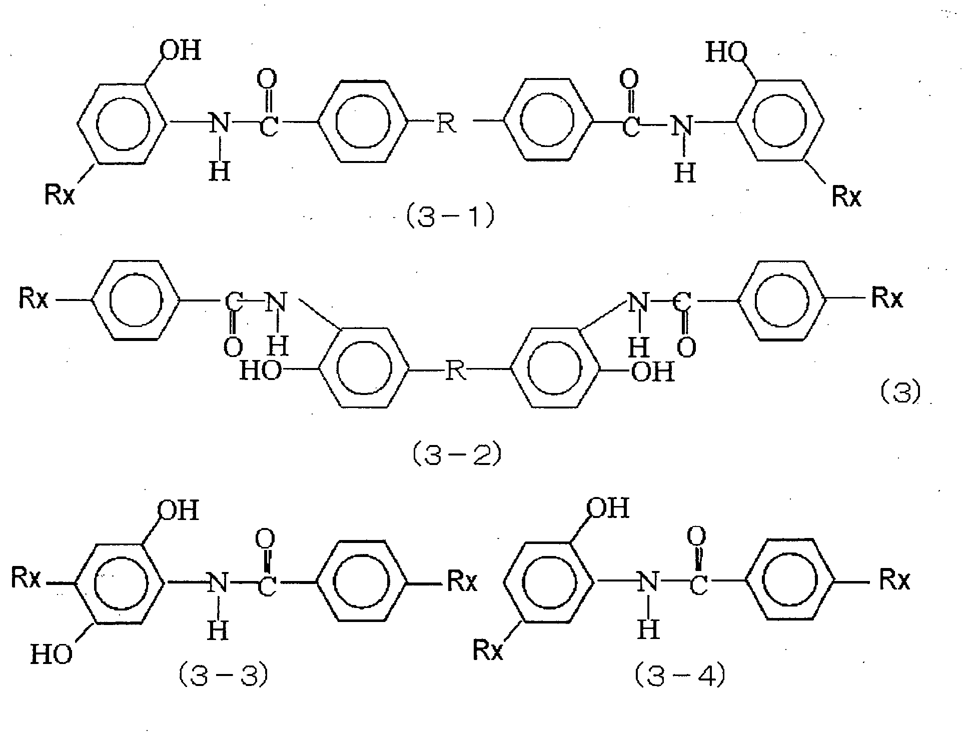

7. The positive photosensitive resin composition as claimed in any of Claims 1 to 6, wherein Y in general formula (1) contains a structure represented by formula [4]:

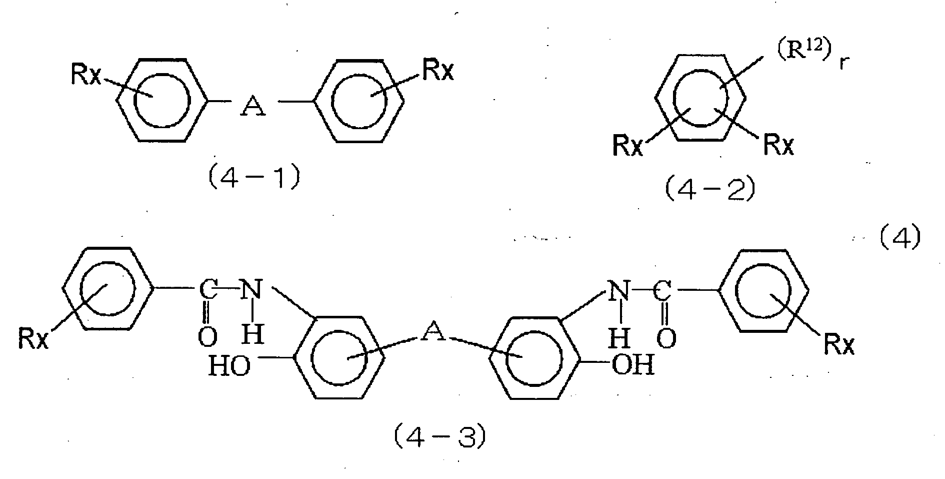

8. A cured film composed of a cured product of the positive photosensitive resin composition as claimed in any of Claims 1 to 7.

9. A protective film consisting of the cured film as claimed in Claim 8.

10. An insulating film consisting of the cured film as claimed in Claim 8.

11. A semiconductor device comprising the cured film as claimed in Claim 8.

12. A display device comprising the cured film as claimed in Claim 8.
